# EUROPEAN PATENT APPLICATION

(11) **EP 4 328 981 A1**
(43) Date of publication of application: **28.02.2024**
(21) Application number: 23759231.6
(22) Date of filing: 23.02.2023
(51) Int. Cl.: H01L 31/0224

(54) **SOLAR CELL PIECE, CELL STRING AND PREPARATION THEREFOR**

(30) Priority: 24.02.2022 CN 202210171553
(71) Applicant: Trina Solar Co., Ltd, Changzhou, Jiangsu 213031 (CN)
(72) Inventor: CHEN, Hong, hangzhou, Jiangsu 213031 (CN); LI, Hancheng, hangzhou, Jiangsu 213031 (CN); FENG, Zhiqiang, hangzhou, Jiangsu 213031 (CN)
(74) Representative: Nederlandsch Octrooibureau
(86) International application number: PCT/CN2023/077854
(87) International publication number: WO 2023/160607

(57) **Abstract**

The present invention provides a solar cell piece, a cell string and a preparation method for the solar cell piece and the cell string. At least one surface of the solar cell comprises multiple first gate line structures, and multiple second gate line structures arranged above the multiple first gate line structures, at least part of the area of the at least one second gate line structure being not in contact with the reaction layer of the solar cell piece. The multiple second gate line structures are suitable for being in contact with connecting structures between the multiple cell pieces. In the solar cell piece in the present invention, the contact between the main gate and the reaction layer can be reduced, the connection between the connection structures between the cell pieces and the main gate can be enhanced, and the efficiency as well as the stability and reliability of the solar cell are improved.

## Description

### Technical Field

The present invention mainly relates to the field of solar cells, and in particular, to a solar cell piece, a cell string and a preparation method for the solar cell piece and the cell string.

### Background

The existing solar cell gate line structure is usually designed such that the main gate is a gate line containing silver, and the auxiliary gate is in some cases a gate line containing aluminum (for example, the auxiliary gate on the back of a P-type perc cell contains aluminum). During the production process in practice, the mainstream printing method is to print the main gate first, and then print the auxiliary gate, so that the main gate and the auxiliary gate can be connected. When welding components, a silver-tin alloy is formed at the welding points between the main gate and the welding ribbons (or other connection structures between solar cell pieces), thereby achieving connection and conductive effects. In this welding method, the current flows through the auxiliary gate to the main gate, and then flows out through the welding ribbons, this non-linear way of deriving current will lead to greater resistance loss, thereby reducing the power of the component. Due to process limitations, there is also a large height difference between the main gate and the auxiliary gate. The height of the auxiliary gate is significantly higher than the height of the main gate, which leads to empty welding between the welding ribbons and the main gate, resulting in poor welding. In addition, the direct contact between the main gate and the reaction layer in existing solar cells will cause damage to the reaction layer and lead to a decrease in efficiency.

### Summary

The technical problem to be solved by the present invention is to provide a solar cell piece, a cell string and a preparation method for the solar cell piece and the cell string. It can reduce the contact between the main gate and the reaction layer and enhance the connection between the main gate and the connection structure between the solar cell pieces, thereby improving the efficiency, the stability and reliability of the solar cell.

In order to solve the above technical problems, the present application provides solar cell piece, at least one surface of the solar cell piece comprises: multiple first gate line structures; multiple second gate line structures, arranged on the multiple first gate line structures, at least part of the an area of the at least one second gate line structure being not in contact with a reaction layer of the solar cell piece; wherein, the multiple second gate line structures are suitable for being in contact with connecting structures between the multiple solar cell pieces.

Optionally, in one embodiment of the present invention, the multiple second gate line structures include multiple lines of and/or multiple segments of arc-shaped structure.

Optionally, in one embodiment of the present invention, the multiple second gate line structures include multiple lines of and/or multiple segments of linear structure.

Optionally, in one embodiment of the present invention, the first gate line structure also includes a linear structure, wherein, the multiple first gate line structures include multiple first gate lines extending along a first direction and arranged along a second direction; the multiple second gate line structures include multiple second gate lines extending along the first direction and arranged along the second direction, and/or extending along the second direction and arranged along the first direction, the multiple second gate lines located on at least part of the multiple first gate lines; and the connection structures include welding ribbon or welding glue, and the welding ribbon or welding glue is in contact with the multiple second gate lines.

Optionally, in one embodiment of the present invention, the multiple second gate lines only extend along the first direction and are arranged along the second direction, the first gate line structure also includes multiple third gate lines extending along the second direction and arranged along the first direction, and the multiple second gate lines span the multiple third gate lines, wherein, the third gate line and the first gate line are composed of the same material.

Optionally, in one embodiment of the present invention, the second gate line structure further includes multiple fourth gate lines extending along the second direction and arranged along the first direction, the multiple fourth gate lines are located on at least part of the third gate lines, the multiple second gate lines span the multiple third gate lines and the multiple fourth gate lines, wherein the fourth gate line and the second gate line are composed of the same material.

Optionally, in one embodiment of the present invention, the multiple second gate lines in the solar cell piece only extend along the second direction and are arranged along the first direction, the first gate line structure further includes multiple third gate lines extending along the second direction and arranged along the first direction, and the multiple second gate lines are located on at least part of the third gate lines, wherein the third gate lines and the first gate lines are composed of the same material.

Optionally, in one embodiment of the present invention, the multiple second gate lines are located on at least part of the multiple first gate lines in a manner that the second gate line half surrounds or completely surrounds the first gate line.

Optionally, in one embodiment of the present invention, the solar cell piece further includes a connecting layer located between the first gate line structure and the second gate line structure.

Optionally, in one embodiment of the present invention, the connecting layer is composed of at least one of inorganic matter, organic matter and metal.

Optionally, in one embodiment of the present invention, a contact surface of the first gate line structure and the second gate line structure undergoes component penetration to form a boundary layer, and the boundary layer includes a portion of the first gate line structure and/or a portion of the second gate line structure.

Optionally, in one embodiment of the present invention, the first gate line structure included in the boundary layer accounts for 1%-99% of the first gate line structure before the component penetration occurs, and the second gate line structure included in the boundary layer accounts for 1%-99% of the second gate line structure before the component penetration occurs.

Another aspect of the present invention also provides a method for preparing solar cell pieces, suitable for preparing solar cell pieces, comprising the following steps: printing multiple first gate line structures on at least one surface of the solar cell piece; printing multiple second gate line structures on the surface, the multiple second gate line structures are located on the multiple first gate line structures, and at least part of an area of at least one second gate line structure is not in contact with a reaction layer of the solar cell pieces; wherein, the multiple second gate line structures are suitable for being in contact with connection structures between multiple solar cell pieces.

Another aspect of the present invention also provides a solar cell string, comprising the solar cell pieces according to any one of the embodiments above, wherein the connection structure sequentially connects two adjacent solar cell pieces to form the solar cell string.

Another aspect of the present invention also provides a method for preparing a solar cell string, comprising the following steps: providing multiple solar cell pieces, each solar cell piece comprises a positive electrode surface and a negative electrode surface, the positive electrode surface and/or the negative electrode surface comprises multiple first gate line structures and multiple second gate line structures, the multiple second gate line structures are located on the multiple first gate line structures, and at least part of an area of at least one second gate line structure is not in contact with a reaction layer of the solar cell pieces; and connecting multiple connection structures to the positive electrode surface and the negative electrode surface of each solar cell piece sequentially, so that the multiple solar cell pieces are connected in series, wherein the connection structure is in contact with the second gate line structure on the positive electrode surface and/or the negative electrode surface.

Compared with the prior art, the solar cell pieces and solar cell strings of the present invention print the main gate on the auxiliary gate line, and then directly weld the main gate to the welding ribbons, thus avoiding empty welding due to insufficient height of the main gate. The solution of the present invention effectively reduces the contact between the main gate and the reaction layer, strengthens the connection between the main gate and the welding ribbons, improves the current efficiency of the cell pieces, and extends the service life of the solar cell pieces.

### Brief Description of the Drawings

The drawings are included to provide a further understanding of the present application, and they are included and constitute a part of the present application, the drawings show the embodiments of the present application, and serving to explain the principles of the present application together with the description. In the drawings:
Fig. 1A is a schematic top view of a solar cell piece in the prior art;
Fig. 1B is a cross-sectional view of the front side of the solar cell pieces shown in Fig. 1A;
Fig. 1C is a schematic back view of a solar cell piece in the prior art;
Fig. 1D is a cross-sectional view of the back side of the solar cell pieces shown in Fig. 1C;
Fig. 2A is a schematic top view of a solar cell piece according to one embodiment 1 of the present invention;
Fig. 2B is a cross-sectional view of the solar cell pieces shown in Fig. 2A;
Fig. 3A is a schematic top view of a solar cell piece according to embodiment 2 of the present invention;
Fig. 3B is a cross-sectional view of the solar cell pieces shown in Fig. 3A;
Fig. 4A is a schematic top view of a solar cell piece according to embodiment 3 of the present invention;
Fig. 4B is a cross-sectional view of the solar cell pieces shown in Fig. 4A;
Fig. 5 is a schematic top view of a solar cell piece according to embodiment 4 of the present invention;
Fig. 6 is a cross-sectional view of the solar cell pieces according to embodiment 5 of the present invention;
Fig. 7 is a schematic flow chart of a method for preparing solar cell pieces according to an embodiment of the present invention;
Fig. 8 is a schematic flow chart of a method for preparing solar cell strings according to an embodiment of the present invention; and
Fig. 9a to Fig. 9c are cross-sectional views of a solar cell pieces with a connecting layer or a boundary layer according to an embodiment of the present invention.

### Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the out of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations "would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present. Likewise, when a first component is referred to as being "electrically contacting" or "electrically coupled to" a second component, there exists an electrical path between the first component and the second component that allows electrical current to flow. This electrical path may include capacitors, coupled inductors, and/or other components that allow current to flow, even without direct contact between conductive components.

The flow chart is used in this application to illustrate the operations performed by the system according to the embodiment of this application. It should be understood that the preceding or following operations are not necessarily performed in an exact order. Instead, various steps may be processed in reverse order or concurrently. At the same time, other operations can either add to these procedures, or a certain step or steps can be removed from these procedures.

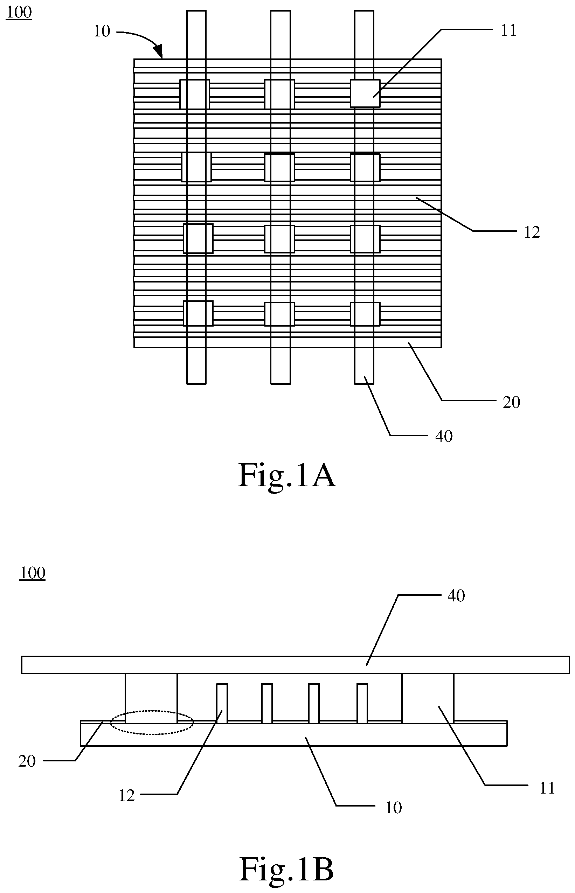

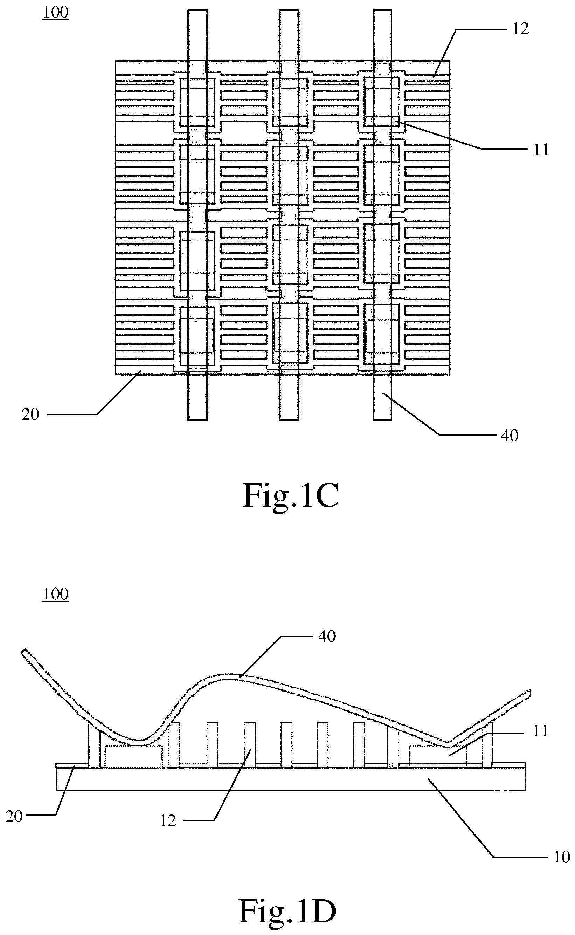

Fig. 1A is a schematic top view of a solar cell piece in the prior art; Fig. 1B is a cross-sectional view of the front side of the solar cell pieces shown in Fig. 1A; Fig. 1C is a back schematic view of a solar cell piece in the prior art; Fig. 1D is a cross-sectional view of the back side of the solar cell pieces shown in Fig. 1C. It can be understood that since the present invention relates to a multiple-layer gate line structure on solar cell pieces, the schematic top view in the drawings of the present invention only illustrates the arrangement structure of the gate lines on the surface of the solar cell pieces, and is different from a schematic top view in general sense. For the upper and lower positional relationships between multiple-layer gate line structures, it is necessary to combine each cross-sectional view and text description for a complete and detailed understanding.

As shown in Fig. 1A to Fig. 1D, the gate line arrangement manner on the front side of the solar cell 100 in the prior art is to directly print the main gate 11 containing silver on the reaction layer 20 covering the surface of the silicon piece 10, and then the connection structure 40 (such as a welding ribbon) is welded on the main gate 11. Although the structural arrangement as shown in Fig. 1A to Fig. 1D is convenient for printing, the consequence is that the main gate 11 is in direct contact with the reaction layer 20 (the area outlined with a dotted circle in Fig. 1B), which will damage the reaction layer 20 and reduce the cell efficiency. In addition, it can be seen especially from Fig. 1D that on the back of the solar cell pieces 100, the height of the main gate 11 is smaller than the auxiliary gate 12, it is difficult to connect the connection structure 40 to the main gate 11, and empty welding is prone to occur, which also affects the efficiency of the battery. It can be seen that there are some defects in the structure of the existing solar cells in which the auxiliary gate is located on the main gate.

It should be noted that the reaction layer 20 shown in Fig. 1A to Fig. 1D as well as the one which will be proposed below according to various embodiments of the present invention is one layer or multiple layers which can play the role of the function of conductivity, passivation, reduction of reflection and/or other protection, electron generation, conductivity of PN junction located in the cell pieces or on the surface of the cell.

The present invention proposes a solar cell piece, any surface of the solar cell piece includes multiple first gate line structures and multiple second gate line structures located on the multiple first gate line structures, and at least part of an area of at least one second gate line structure is not in contact with the reaction layer of the solar cell piece; wherein, the multiple second gate line structures are suitable for contacting the connection structures between the multiple solar cell pieces. Such a structure can effectively reduce the contact between the main gate and the reaction layer and enhance the connection between the main gate and the welding ribbon, thereby improving the efficiency and the stability and reliability of the solar cell.

It should be noted that the present invention does not impose specific limitations on the type of cells. Therefore, in different embodiments of the present invention, the solar cell may have two opposite surfaces, or may have only one surface (such as a back junction cell IBC). If the solar cell has two opposite surfaces, any one of the two surfaces may include first gate line structures and second gate line structures, which will be described in detail below. And if the solar cell only has single surface, and the single surface has both the positive and negative electrodes of the cell, then in such an embodiment, the first gate line structures and the second gate line structures are both on the single surface. On the other hand, the present invention does not limit the shapes of the first gate line structures and the second gate line structures. Specifically, in some embodiments of the present invention, the multiple second gate line structures include multiple lines and/or multiple segments of arc-shaped structures. In addition, the second gate line structures on the solar cell pieces provided by the present invention can be composed of only multiple lines and/or multiple segments of arc-shaped structures, or can be composed of only multiple lines and/or multiple segments of linear structures, it may also include both the multiple lines and/or multi-segment of arc structures and multiple lines and/or multiple segments of linear structures, and the specific combination manner is not specifically limited in this application.

### Embodiment 1

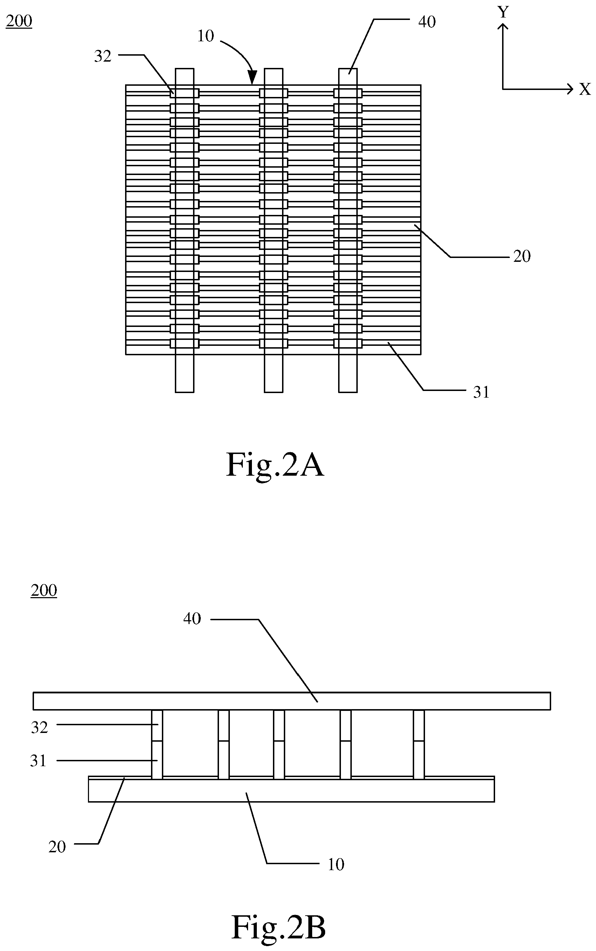

Fig. 2A is a schematic top view of a solar cell piece 200 according to embodiment 1 of the present invention; Fig. 2B is a cross-sectional view of the solar cell pieces shown in Fig. 2A.

In the embodiment shown in Fig. 2A and Fig. 2B, both the first gate line structure 31 and the second gate line structure 32 are linear structures, and in this embodiment, with reference to the coordinate axis shown in Fig. 2A, the X-axis is set as the first direction, and the Y-axis direction is set as the second direction. It can be understood that the above-mentioned first direction X and second direction Y only illustrate the relative positions of the first gate line 31 and the second gate line 32, but do not mean that the two lines must intersect each other at right angles. In addition, what is shown in Fig. 2A and Fig. 2B, may be any surface of the solar cell piece 200; for example, for a double-surface cell, the any surface can be the front or back thereof; or for a single-surface cell, what is shown in Fig. 2A and Fig. 2B is the single-surface.

According to Fig. 2A and Fig. 2B, any surface of the solar cell 200 includes: multiple first gate lines 31 extending along the first direction X and arranged along the second direction Y; multiple second gate lines 32 extending along the first direction X and arranged along the second direction Y; the multiple second gate lines 32 are located on the multiple first gate lines 31; and the connection structure (specifically, a welding ribbon) 40 spans the multiple first gate lines 31 and is connected to the multiple second gate lines 32 (specifically, it can be welded on the second gate line structure 32).

For example, in the embodiments shown in Fig. 2A and Fig. 2B, the composition of the second gate line 32 includes silver (which can be referred to the main gate in traditional preparation methods). As for the first gate line 31, it can be referred to the auxiliary gate in the traditional preparation method, in some embodiments of the present invention, the first gate line can contain silver; for example, it is the auxiliary gate line on the back of the P-type perc cell. It can be understood that although such an example is illustrated, the present invention does not place any specific limitations on the materials of the first gate line and the second gate line. It can be seen from Fig. 2A that the solar cell piece 200 can be considered to adopt a main gate pad structure, that is, the second gate line 32 (main gate) can be abstracted as a pad point, serving connection function by connecting to connection structure 40 (such as welding ribbon).

Specifically, in order to position the multiple second gate lines 32 on at least part of the multiple first gate lines 31, in the specific printing process, the first gate lines 31 are firstly printed on the reaction layer 20 covering the silicon pieces 10 (auxiliary gate), and then print the second gate line 32 (main gate), so that the second gate line 32 is located on the first gate line 31. Such a structure can effectively reduce the contact between the second gate line 32 and the reaction layer 20, which reduce the loss of the reaction layer 20, and improve the cell efficiency.

In the embodiment shown in Fig. 2A and Fig. 2B, each first gate line 31 is of a second gate line 32 on top, but the present invention does not limit scope to such a structuree. For example, in some other embodiments, the multiple second gate lines 32 are only located on part of the multiple first gate lines 31. For example, in some embodiments, the second gate lines 32 are only located on some of the first gate lines 31, and some of the first gate lines 31 are not provided with the second gate lines 32.

It can be understood that, as shown in Fig. 2A and Fig. 2B, a preferred embodiment of the present invention is provided, that the length of the second gate line 32 is less than the length of the first gate line 31, that is, the second gate line 32 is discretely arranged on the first gate lines 31. Compared with the continuous arrangement, this arrangement can reduce the consumption of silver of the second gate line and further reduce costs. In addition, as shown in Fig. 2A, the width of the second gate line 32 is slightly greater than the width of the first gate line 31, and the length of the second gate line 32 is also greater than the width of the connection structure 40, thus ensuring the current collection effect of the first gate line 31, improving the welding efficiency between the second gate line 32 and the connection structure 40, and enhancing the stability of the cell.

### Embodiment 2

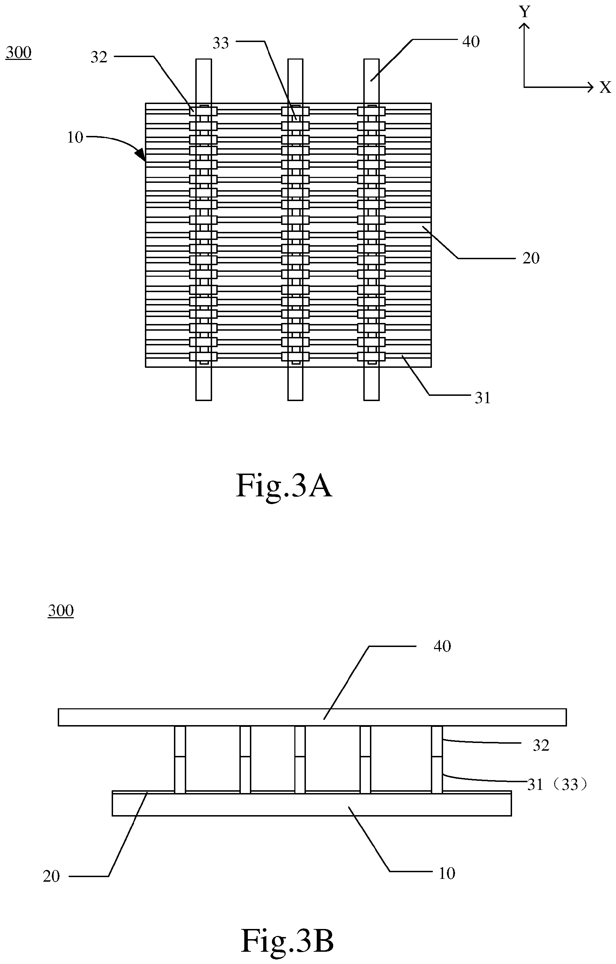

Fig. 3A is a schematic top view of a solar cell piece 300 according to embodiment 2 of the present invention; Fig. 3B is a cross-sectional view of the solar cell pieces shown in Fig. 3A; embodiment 2 is a further modification based on embodiment 1. Similar to the above-mentioned embodiment 1, in this embodiment, the first direction X and the second direction Y are also set, and what is shown Fig. 3A and Fig. 3B is any surface of the solar cell 300.

In the embodiment shown in Fig. 3A to Fig. 3B, the multiple second gate lines 32 in the solar cell piece only extend along the first direction X and are arranged along the second direction Y. The first gate line structure in the solar cell piece 300 also includes multiple third gate lines 33 extending along the second direction Y and arranged along the first direction X, the multiple second gate lines 32 span the multiple third gate lines 33, wherein the third gate line 33 and the first gate line 31 are composed of the same material.

Referring to Fig. 3A, in this embodiment, the solar cell piece 300 is provided with multiple first gate lines 31 extending along the first direction X and arranged along the second direction Y, multiple second gate lines 32 extending along the first direction X and arranged along the second direction Y, as well as multiple third gate lines 32 extending along the second direction Y and arranged along the first direction X. In this embodiment, the third gate line 33 is composed of the same material as the first gate line 31 (or can be understood to be also an auxiliary gate).

Specifically, in the embodiment shown in Fig. 3A, the third gate line 33 is located below the multiple second gate lines 32 and is in contact with the multiple second gate lines 32. In order to better understand the structure of the solar cell piece 300, during the specific printing process, the first gate lines 31 and the third gate lines 33 can be printed first, and then the second gate lines 32 that containing silver is printed. Preferably, in some embodiments of the present invention, since the first gate line 31 and the third gate line 33 are composed of the same material, the two lines can be integrally printed through a mold. In some other embodiments, the first gate line 31 and the third gate line 33 can also be separated into multiple layers for printing.

Similarly, the structure of Fig. 3A and Fig. 3B is to make the second gate line 32 located on the first gate line 31 and the third gate line 33, so as not to contact the reaction layer 20, thereby reducing damage to the reaction layer 20, and improving cell efficiency. In addition, compared with the embodiment 1, the solar cell 300 provided in this embodiment adds multiple third gate lines 33 on the basis of the first gate lines 31, thereby improving the efficiency of current collection.

### Embodiment 3

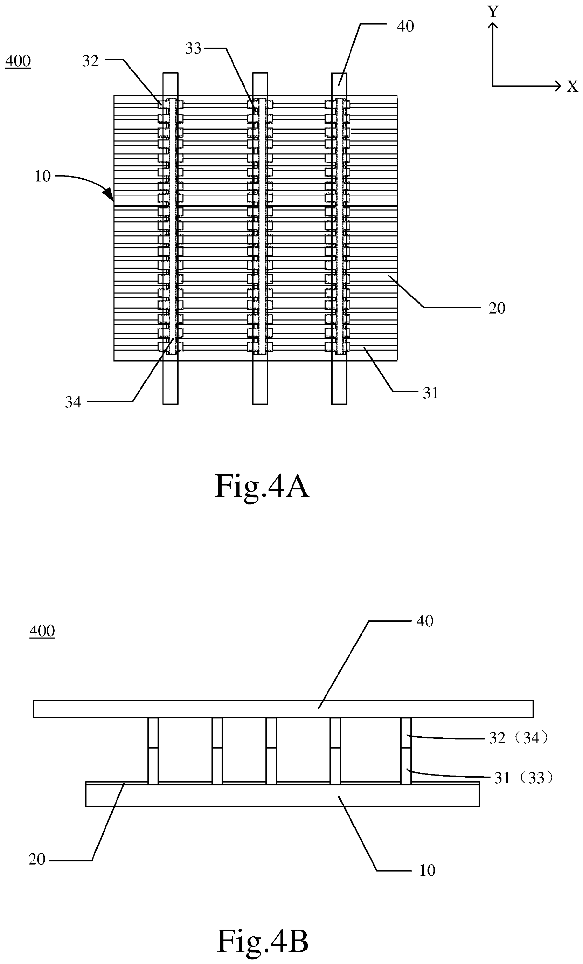

Fig. 4A is a schematic top view of a solar cell piece 400 according to embodiment 3 of the present invention; Fig. 4B is a cross-sectional view of the solar cell pieces shown in Fig. 4A. Embodiment 3 is a further modification based on embodiment 2. In the embodiment shown in Fig. 4A~Fig. 4B, the solar cell piece 400 is based on the solar cell piece 300 shown in Fig. 3A-Fig. 3B, and further includes multiple fourth gate lines 34 extending along the second direction Y and arranged along the first direction X. The multiple fourth gate lines 34 are located on the third gate lines 33, and the multiple second gate lines 32 span the multiple third gate lines 33 and the multiple fourth gate lines 34 in the arrangement direction, wherein the fourth gate lines 34 and the second gate line 32 are composed of the same material (or can be understood as the same main gate).

Referring to Fig. 4A, compared with the embodiment 3, a solar cell piece 400 illustrated in this embodiment is provided with multiple first gate line 31 extending along the first direction X and arranged along the second direction Y, multiple second gate lines 32 extending along the first direction X and arranged along the second direction Y, and multiple third gate lines 33 extending along the second direction Y and arranged along the first direction X, as well as multiple fourth gate lines 34 extending along the second direction Y and arranged along the first direction X, and the multiple fourth gate lines 34 are located on the third gate lines 33. It can be understood that in the embodiment shown in Fig. 4A, a fourth gate line 34 is arranged on each third gate line 33, but the present invention is not limited thereto. In some other embodiments of the present invention, the fourth gate line 34 is only located on some of the third gate lines 33, and some other third gate lines 33 are not provided with the fourth gate line 34
Furthermore, in this embodiment, the fourth gate line 34 is composed of the same material as the second gate line 32. In order to better understand the structure of the solar cell pieces 400, during the specific printing process, the first gate line 31 and the third gate line 32 can be printed first, and then the second gate line 32 and the fourth gate line 34 are printed. Similarly, in some embodiments of the present invention, since the first gate line 31 and the third gate line 33 are composed of the same material, and the second gate line 32 and the fourth gate line 34 are also composed of the same material, these two sets of gate lines can be printed in integration through a mold. In some other embodiments, each gate line can also be printed separately.

Similarly, the structure of the solar cell piece 400 shown in Fig. 4A and Fig. 4B allows the second gate line 32 and the fourth gate line 34 to be located on the first gate line 31 and the third gate line 33, thereby preventing the silver-containing material from contacting with the reaction layer 20. Compared with embodiment 2, and based on the above embodiments, this embodiment is adjusted by adding a fourth gate line 34 (main gate) in the Y direction, so that the current can be more effectively collected to the welding structure 40 and the efficiency of solar cells improves, which further enhances the stability and reliability of solar cells.

### Embodiment 4

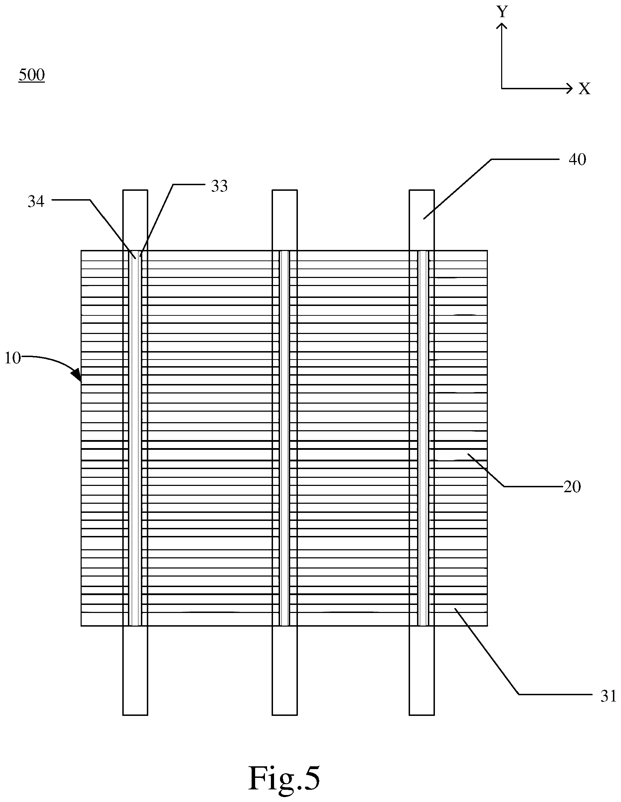

Fig. 5 is a schematic top view of a solar cell piece 500 according to embodiment 4 of the present invention. Embodiment 4 can be understood as a further modification based on embodiment 3 shown in Fig. 4A- Fig. 4B. In the embodiment shown in Fig. 5, any surface of the solar cell piece only has multiple second gate lines 34 extending along the second direction Y and arranged along the first direction. The solar cell piece 500 also includes multiple third gate lines 33 extending in the direction Y and arranged along the first direction X. The multiple second gate lines 34 are located on the third gate lines 33, and the third gate lines 33 and the first gate lines 31 are composed of the same material. In this embodiment, the first gate line 31 and the third gate line 33 can be understood as auxiliary gates, and the second gate line 34 can be understood as a main gate, wherein the second gate lines 34 and the third gate lines 33 have the same direction, and the second gate lines 34 are located on all the third gate lines 33. Optionally, in some embodiments, the second gate lines 34 are only located on some of the third gate lines 33, and some other third gate lines 33 are not provided with the second gate lines 34.

In this embodiment, compared with the solar cell piece 400 shown in Fig. 4A and Fig. 4B, only the second gate lines 34 extending in the Y direction remain on any surface of the solar cell piece 500. Therefore, while ensuring the above technical effects, the consumption of silver paste can also be reduced, thereby saving costs.

### Embodiment 5

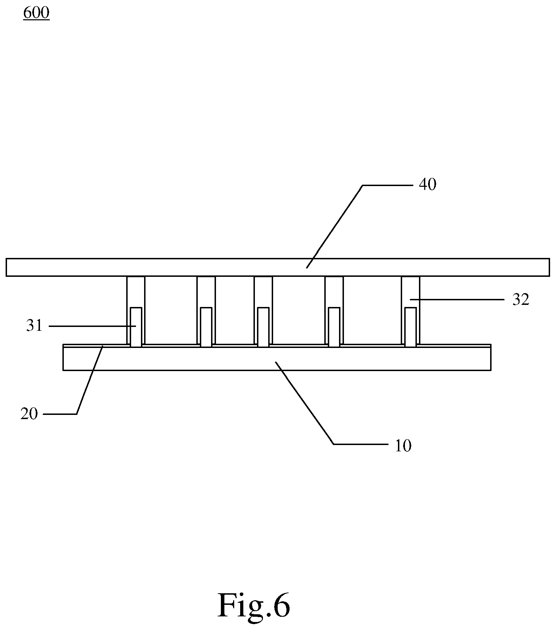

Fig. 6 is a cross-sectional view of the solar cell piece 600 according to embodiment 5 of the present invention. For example, the solar cell piece 600 shown in Fig. 6 can be combined with the solar cell piece 200 to 500 in the embodiments 1∼4 described with reference to Fig. 2A to Fig. 5 to form more embodiments.

Specifically, as shown in Fig. 6, in the solar cell piece 600, the multiple second gate lines 32 are located on the multiple first gate lines 31, in such a manner, the second gate line 32 half surrounds or fully surrounds the first gate line 31. This means that in the embodiment shown in Fig. 6, the second gate line 32 is allowed to partially contact the reaction layer 20.

For example, if some of the second gate lines 32 completely surrounds the first gate line 31, the width of the second gate line 32 may be greater than the first gate line 31, that is, the left and right sides of the auxiliary gate are covered with part of the main gate. In this embodiment, the upper surface and left and right sides of the first gate line 31 are covered with a part of the second gate line (containing silver), this part of the silver-containing component can enhance the reflection effect of light, thereby improving the efficiency of the solar cell. In some other embodiments, the second gate line 32 half surrounds the first gate line 31, that is, one side of the left and right sides of the first gate line 31 is covered with a silver-containing component of the second gate line 32, and the other side is in a state of nudity. In this embodiment, the upper surface of the first gate line 31 is also covered with the silver-containing component of the second gate line, and the lower surface is in contact with the reaction layer 20. It can be understood that, no matter whether the second gate line 32 partially surrounds or completely surrounds the first gate line 31, although it has partial contact with the reaction layer 20, the contact area is small. Compared with the main gate that is completely in contact with the reaction layer 20 in the prior art, the structure of the present invention can still achieve the technical effects of reducing losses and improving efficiency.

On the other hand, it should be noted that in the above-mentioned embodiments of the present invention, the connection structure 40 can be replaced with a connection structure of other materials and shapes such as welding glue in addition to the welding ribbons shown in each drawing, to achieve the purpose of contacting multiple second gate lines 32 and connecting multiple cell pieces.

It should be emphasized that in the solar cell provided by the present invention, at least part of an area of at least one second gate line structure is not in contact with the reaction layer of the solar cell. Although in the drawings of the above-mentioned embodiments 1 to 4 of the present invention, each second gate line is preferably not entirely or partly in contact with the reaction layer, the present invention is not limited to such structures. In particular, the degree of contact between the second gate line structure and the reaction layer of the solar cell piece as well as the specific contact manner are not limited to the above-mentioned embodiments.

Specifically, in some other embodiments of the present invention, taking as an example that all the first gate line structures and the second gate line structures are linear structures, only one or some second gate lines are in partial or complete contact with the reaction layer; or, in one or some second gate lines, a part of any second gate line may be in contact with the reaction layer. In some embodiments, a portion of the second gate line is in direct contact with the reaction layer, a portion of the second gate line is printed on the first gate line, and the portion of the second gate line located on the first gate line includes a component that is not in contact with the reaction layer at all. It can be understood that the above-mentioned situation where one or some second gate line structures are all in contact with the reaction layer can be understood as modifying part of the second gate lines (ie, the main gate) to the arrangement provided by the present invention based on the prior art (all main gates are in complete contact with the reaction layer).

In addition, in embodiment 5 of the present invention, a specific way is provided in which at least part of the second gate line structure is not in contact with the reaction layer, that is, the second gate line is located on the first side in a partly surround or fully surround manner.

Regardless of the above method, the solar cell piece proposed by the present invention prevents at least part of the second gate line structure from contacting the reaction layer of the solar cell pieces, thereby reducing the contact between the main gate and the reaction layer and strengthening the connection between the main gate and the welding ribbon, which improves the efficiency as well as the stability and reliability of the solar cell.

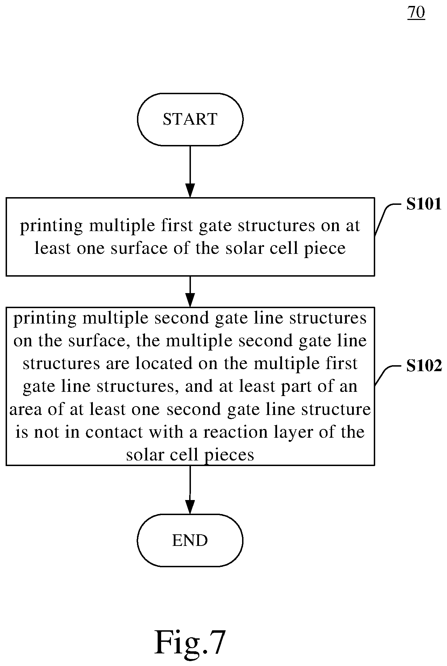

Fig. 7 is a schematic flow chart of a method 70 for preparing solar cell piece according to an embodiment of the present invention. Referring to Fig. 7, the present invention provides a method 70 for preparing solar cells piece, which is suitable for preparing the solar cell piece as described above. The preparation method 70 of solar cell pieces comprises the following steps:
S101: printing multiple first gate line structures on at least one surface of the solar cell piece;
S102: printing multiple second gate line structures on the surface, the multiple second gate line structures are located on the multiple first gate line structures, and at least part of an area of at least one second gate line structure is not in contact with a reaction layer of the solar cell pieces;
wherein, in S102, the multiple second gate line structures are suitable for contacting the connection structures between the multiple solar cell pieces.

It can be understood that the preparation method of solar cell pieces provided in this embodiment is applicable to the solar cell pieces in all the above embodiments with reference to Fig. 2A to Fig. 6, more details about the preparation method 70 of solar cell pieces can be referred to the above description and will repeat in details in this part.

Furthermore, based on the structure of the above-mentioned solar cell pieces, the present invention also provides a solar cell string, including a solar cell piece proposed by the present invention, such as the solar cell piece described in any of the above embodiments, wherein, the connection structure connects two adjacent solar cell pieces in sequence to form a solar cell string.

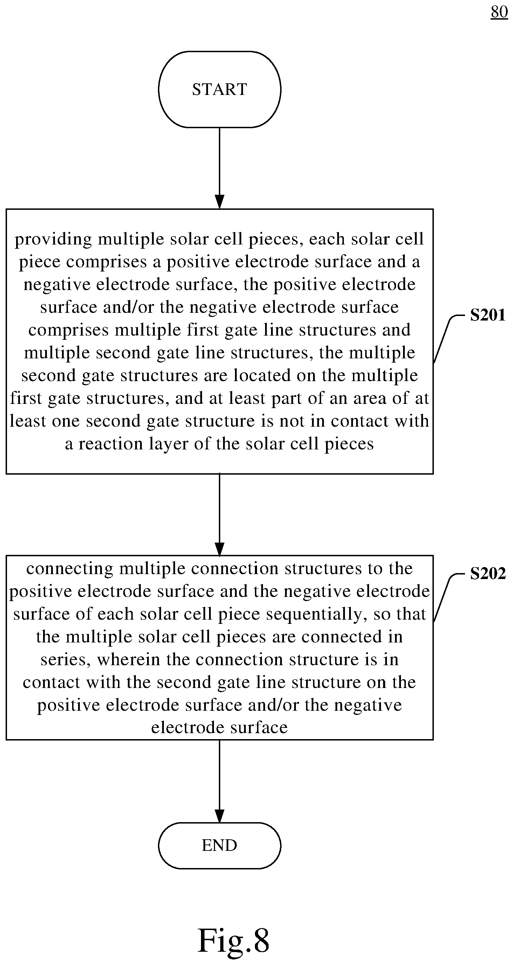

Correspondingly, the present invention also provides a method for preparing a solar cell string, Fig. 8 is a schematic flow chart of a method for preparing solar cell strings according to an embodiment of the present invention. Referring to Fig. 8, the solar cell string preparation method 80 comprises the following steps:
S201: providing multiple solar cell pieces, each solar cell piece comprises a positive electrode surface and a negative electrode surface, the positive electrode surface and/or the negative electrode surface comprises multiple first gate line structures and multiple second gate line structures, the multiple second gate line structures are located on the multiple first gate line structures, and at least part of an area of at least one second gate line structure is not in contact with a reaction layer of the solar cell pieces;
S202: connecting multiple connection structures to the positive electrode surface and the negative electrode surface of each solar cell piece sequentially, so that the multiple solar cell pieces are connected in series, wherein the connection structure is in contact with the second gate line structure on the positive electrode surface and/or the negative electrode surface.

Specifically, in one embodiment of the present invention, each cell piece in step S201 includes an opposite positive electrode surface and a negative electrode surface, both the positive electrode surface and the negative electrode surface have multiple first gate lines extending along the first direction and arranged along the second direction, and multiple second gate lines extending along the first direction and arranged along the second direction and/or extending along the second direction and arranged along the first direction, and the multiple second gate lines are located on at least part or some of the multiple first gate lines; In step S202, each connection structure is welded on the second gate line in a manner spanning multiple first gate lines. In addition, in some other embodiments of the present invention, the solar cell piece only has a single-sided gate line structure, and in the above-mentioned preparation method 70, the first gate line structure and the second gate line structure proposed by the present invention can be respectively prepared in the single-surface positive and negative electrode areas. Similarly, regarding the preparation method 80 of the solar cell string, reference can also be made to the above description, which will not be repeated in details in this part.

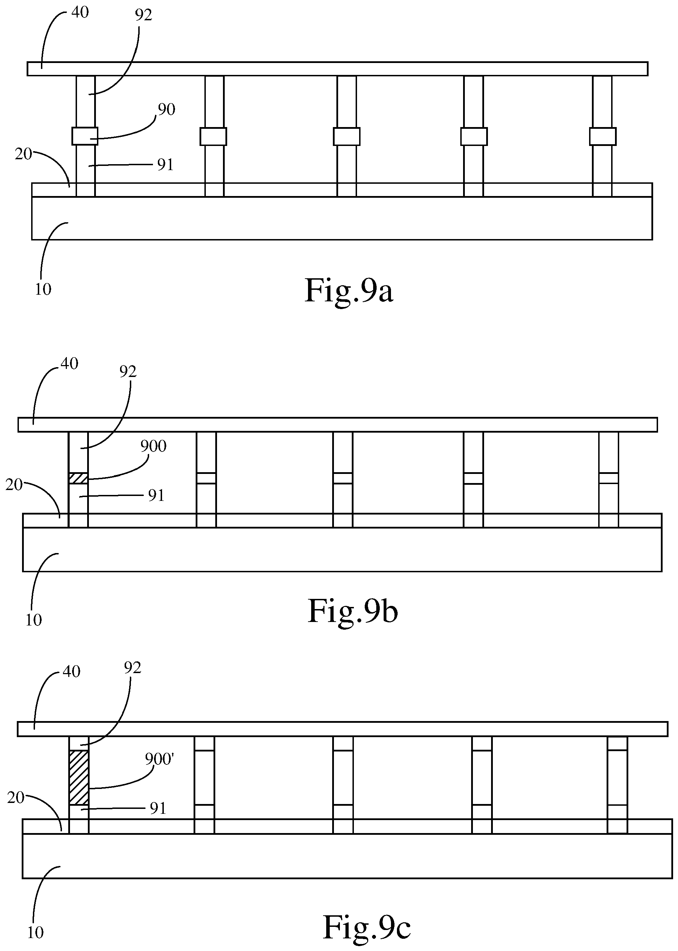

Finally, further explanation is illustrated on the gate line structure of the solar cell pieces of the present invention. In the present invention, the first gate line structure and the second gate line structure on the solar cell pieces are expressed as "first" and "second" just to distinguish that they are located at different positions or at different levels relative to the reaction layer on the surface of the solar cell. In some embodiments of the present invention, the first gate line structure and the second gate line structure may have obvious or additional boundaries, may not have obvious boundaries with each other, or even form a special interface layer through material penetration. A detailed description will be given below with reference to Fig. 9a to Fig. 9c. In the embodiments shown in Fig. 9a to Fig. 9c, the first gate line structure and the second gate line structure are still taking multiple lines or multiple segments linear structures as example.

As shown in Fig. 9a, in this embodiment, there is also a connecting layer 90 between the first gate line 91 and the second gate line 92, this connecting layer can enhance the connection between the first gate line 91 and the second gate line 92. For example, the material of the connecting layer 90 can be one or more materials selected from inorganic materials, organic materials, and metals, and the present invention is not limited thereto. In particular, the connecting layer 90 may be a layer completely independent of the first gate line 91 and the second gate line 92, while it is not excluded that in some embodiments of the present invention, due to material penetration, the connecting layer 90 has parts of the first gate line 91 and the second gate line 92. In such an embodiment, due to the connection layer, the connection strength between the first gate line structure and the second gate line structure can be enhanced, further improving the stability of the cell.

Further, in the embodiment shown in Fig. 9b and Fig. 9c, the first gate line 91 and the second gate line 92 are still in direct contact with each other, but what is different from the embodiment shown in Fig. 9a is that the components in the part where the first gate line 91 and the second gate line 92 contact each other (contact surface) occurs material penetration, thereby forming the boundary layers 900 and 900' as shown in Fig. 9b and Fig. 9c. Both the boundary layer 900 and the boundary layer 900' contain part of the first gate line 91 and/or the second gate line 92. In such an embodiment, the contact resistance between the first gate line 91 and the second gate line 92 is relatively small, and the connection force between the two is relatively stronger, thereby achieving further optimized solar cell pieces.

It can be seen from Fig. 9b and Fig. 9c that the heights of the boundary layers 900 and 900' in the cross-sections shown in the drawings are different, which means that the material composition of the first gate line 91 and/or the second gate line 92 contained in the boundary layer in the two embodiments is somewhat different. Exemplarily, in some embodiments of the present invention, the first gate line structure included in the boundary layer accounts for 1%-99% of the first gate line structure before penetration of the component occurs, the second gate line structure included in the boundary layer accounts for 1%-99% of the second gate line structure before penetration of the component occurs. This means that in the embodiment where component penetration occurs, as long as part of the second gate line structure (such as the second gate line 92) is not in contact with the reaction layer 20, the technical effects of the present invention can be achieved.

The solar cell pieces and solar cell strings provided by the present invention print the main gate on the auxiliary gate, and then weld the main gate to the connection structure, thereby avoiding empty welding due to insufficient main gate height, and the contact between the main gate and the reaction layer 20 is effectively reduced, the connection between the main gate and the connection structure is enhanced, the current efficiency of the cells is improved and the service life of the solar cell piece is extended.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A solar cell piece, **characterized in that**, at least one surface of the solar cell piece comprises:
multiple first gate line structures;
multiple second gate line structures, arranged on the multiple first gate line structures, at least part of an area of at least one second gate line structure being not in contact with a reaction layer of the solar cell piece;
wherein, the multiple second gate line structures are suitable for being in contact with connecting structures between multiple solar cell pieces.

2. The solar cell piece according to claim 1, **characterized in that**, the multiple second gate line structures include multiple lines of and/or multiple segments of arc-shaped structure.

3. The solar cell piece according to claim 1, **characterized in that**, the multiple second gate line structures include multiple lines of and/or multiple segments of linear structure.

4. The solar cell piece according to claim 3, **characterized in that**, the first gate line structure also includes a linear structure, wherein,
the multiple first gate line structures include multiple first gate lines extending along a first direction and arranged along a second direction;
the multiple second gate line structures include multiple second gate lines extending along the first direction and arranged along the second direction, and/or extending along the second direction and arranged along the first direction, the multiple second gate lines located on at least part of the multiple first gate lines;
and the connection structures include welding ribbon or welding glue, and the welding ribbon or welding glue is in contact with the multiple second gate lines.

5. The solar cell piece according to claim 4, **characterized in that**, the multiple second gate lines only extend along the first direction and are arranged along the second direction, the first gate line structure also includes multiple third gate lines extending along the second direction and arranged along the first direction, and the multiple second gate lines span the multiple third gate lines, wherein, the third gate line and the first gate line are composed of the same material.

6. The solar cell piece according to claim 5, **characterized in that**, the second gate line structure further includes multiple fourth gate lines extending along the second direction and arranged along the first direction, the multiple fourth gate lines are located on at least part of the third gate lines, the multiple second gate lines span the multiple third gate lines and the multiple fourth gate lines, wherein the fourth gate line and the second gate line are composed of the same material.

7. The solar cell piece according to claim 4, **characterized in that**, the multiple second gate lines in the solar cell piece only extend along the second direction and are arranged along the first direction, the first gate line structure further includes multiple third gate lines extending along the second direction and arranged along the first direction, and the multiple second gate lines are located on at least part of the third gate lines, wherein the third gate lines and the first gate lines are composed of the same material.

8. The solar cell piece according to any one of claims 4-7, **characterized in that**, the multiple second gate lines are located on at least part of the multiple first gate lines in a manner that the second gate line half surrounds or completely surrounds the first gate line.

9. The solar cell piece according to any one of claims 1~3, **characterized in that**, the solar cell piece further includes a connecting layer located between the first gate line structure and the second gate line structure.

10. The solar cell piece in claim 9, **characterized in that**, the connecting layer is composed of at least one of inorganic matter, organic matter and metal.

11. The solar cell piece according to any one of claims 1~3, **characterized in that**, a contact surface of the first gate line structure and the second gate line structure undergoes component penetration to form a boundary layer, and the boundary layer includes a portion of the first gate line structure and/or a portion of the second gate line structure.

12. The solar cell piece according to claim 11, **characterized in that**, the first gate line structure included in the boundary layer accounts for 1%-99% of the first gate line structure before the component penetration occurs, and the second gate line structure included in the boundary layer accounts for 1%-99% of the second gate line structure before the component penetration occurs.

13. A method for preparing solar cell pieces, suitable for preparing solar cell pieces, **characterized in that**, comprising following steps:
printing multiple first gate line structures on at least one surface of the solar cell piece;
printing multiple second gate line structures on the surface, the multiple second gate line structures are located on the multiple first gate line structures, and at least part of an area of at least one second gate line structure is not in contact with a reaction layer of the solar cell pieces;
wherein, the multiple second gate line structures are suitable for being in contact with connection structures between multiple solar cell pieces.

14. A solar cell string, **characterized in that**, comprising the solar cell pieces according to any one of claims 1 to 12, wherein the connection structure sequentially connects two adjacent solar cell pieces to form the solar cell string.

15. A method for preparing a solar cell string, **characterized in that**, comprising the following steps:
providing multiple solar cell pieces, each solar cell piece comprises a positive electrode surface and a negative electrode surface, the positive electrode surface and/or the negative electrode surface comprises multiple first gate line structures and multiple second gate line structures, the multiple second gate line structures are located on the multiple first gate line structures, and at least part of an area of at least one second gate line structure is not in contact with a reaction layer of the solar cell pieces; and
connecting multiple connection structures to the positive electrode surface and the negative electrode surface of each solar cell piece sequentially, so that the multiple solar cell pieces are connected in series, wherein the connection structure is in contact with the second gate line structure on the positive electrode surface and/or the negative electrode surface.
